# EUROPEAN PATENT APPLICATION

(11) **EP 4 827 307 A1**
(43) Date of publication of application: **21.10.2026**
(21) Application number: 26168651.3
(22) Date of filing: 27.03.2026
(51) Int. Cl.: H10P 72/10

(54) **WAFER BOAT**

(30) Priority: 31.03.2025 US 202563781064 P
(71) Applicant: ASM IP Holding B.V., 1322 AP Almere (NL)
(72) Inventor: MARANDI, Kianoosh, 1322 AP Almere (NL)
(74) Representative: V.O.

(57) **Abstract**

A wafer boat for carrying a plurality of wafers is disclosed. The wafer boat comprises a bottom member, a top member, and at least three rods, each rod extending between the bottom member and the top member and comprising a plurality of wafer supports. Each rod comprises a stress control cut-out region to limit thermal stresses between the rod and the bottom member.

## Description

### FIELD

The present disclosure relates generally to the field of semiconductor processing methods, and associated structures and apparatus, and to the field of device and integrated circuit manufacture. More particularly the present disclosure generally relates to wafer carriers for use in batch semiconductor processing apparatuses.

### BACKGROUND

In the field of semiconductor manufacturing, wafer boats are a critical component of batch processing apparatuses, including but not limited to vertical furnaces. These boats are designed to hold multiple semiconductor wafers simultaneously during processes which may take place at high temperatures, playing a vital role in achieving the desired throughput for commercial production.

The ability to accommodate a larger number of wafers without compromising the boat's stability is an important consideration. Stability is essential not only to ensure uniform processing of all wafers but also to mitigate the risk of mechanical failures during operation. Wafer boats must maintain their structural integrity while being subjected to mechanical handling and the high thermal gradients characteristic of semiconductor processing. The operational environment for these wafer boats often includes high-temperature processes exceeding 1000°C, such as is common in oxidation and diffusion processes. Prolonged exposure to such extreme temperatures induces significant thermal stress on the wafer boat. This stress can lead to material deformation, cracking, or other forms of degradation, which in turn compromise the uniformity and quality of the semiconductor wafers being processed.

Consequently, developing wafer boats with enhanced thermal stability and resistance to high-temperature stresses is a crucial challenge in the industry.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a wafer boat for carrying a plurality of wafers which includes a bottom member, a top member, and at least three rods, each rod extending between the bottom member and the top member and including a plurality of wafer supports, wherein each rod includes a stress control cut-out region to limit thermal stresses between the rod and the bottom member.

By including the stress control cut-out region, a boat according to embodiments of the present invention may exhibit improved resistance to large temperature gradients. A boat according to embodiments of the present invention may be able to withstand higher temperature gradients without damage as compared with a reference boat not comprising the stress control cut out region.

In some embodiments, the cut-out region is provided between the bottom member and a support in the plurality of wafer supports which is closest to the bottom member.

In some embodiments, the bottom member and the top member are spaced apart in a first direction, wherein each rod has a length, at a wafer support position, in a second direction perpendicular to the first direction which is greater than a length, at a wafer support position, in a third direction perpendicular to the first direction and the second direction.

In some embodiments, a maximum length of a rod in the second direction is at least three times a maximum length of the rod in the third direction.

In some embodiments, the cut-outs are provided so as to reduce the length of the rod in the second direction at a position of the cut-outs.

In some embodiments, a length of the rod in the second direction at a position of the cut-outs is between 20% and 70% of a length of the rod in the second direction at a wafer support position.

In some embodiments, the cut-outs are provided at a first side of the boat rod and at a second, opposite side of the boat rod, wherein the first side and the second side are spaced apart in the second direction.

In some embodiments, each cut-out on a rod has substantially a same shape.

In some embodiments, no cut-out is provided so as to reduce the length of the rod in the third direction at a position of the cut-outs.

In some embodiments, each rod includes an additional stress control cut-out region to limit thermal stresses between the rod and the top member.

In some embodiments, the additional stress control cut-out region is provided between the top member and a support in the plurality of wafer supports which is closest to the top member.

In some embodiments, the plurality of wafer supports are finger shaped.

In some embodiments, the wafer boat is made of silicon.

In some embodiments, the wafer boat includes at least 100 wafer supports.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a perspective view of a boat according to embodiments of the present invention;
FIG. 2 is a cross-sectional view in a vertical plane of a rod comprised in a boat according to embodiments of the present invention, having a cut-out region in a lower section;
FIG. 3 is a view of a boat according to embodiments of the present invention along the first direction and towards the bottom member, as seen from a point between the bottom member and the top member;
FIG. 4 is a top view of a support which may be comprised in a boat according to embodiments of the present invention;
FIG. 5 is a cross-sectional view of a rod taken at a position in the first direction which corresponds to a position of a cut-out region;
FIG. 6 is a cross-sectional view in a vertical plane of a rod comprised in a boat according to embodiments of the present invention, having a cut-out region in a lower section and in an upper section.
FIG. 7 is a plot of maximum von Mises yield criterion divided by yield stress as a function of maximum temperature for two boats according to embodiments of the present invention, showing also a reference plot for a boat which does not comprise a stress relief cut out region.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

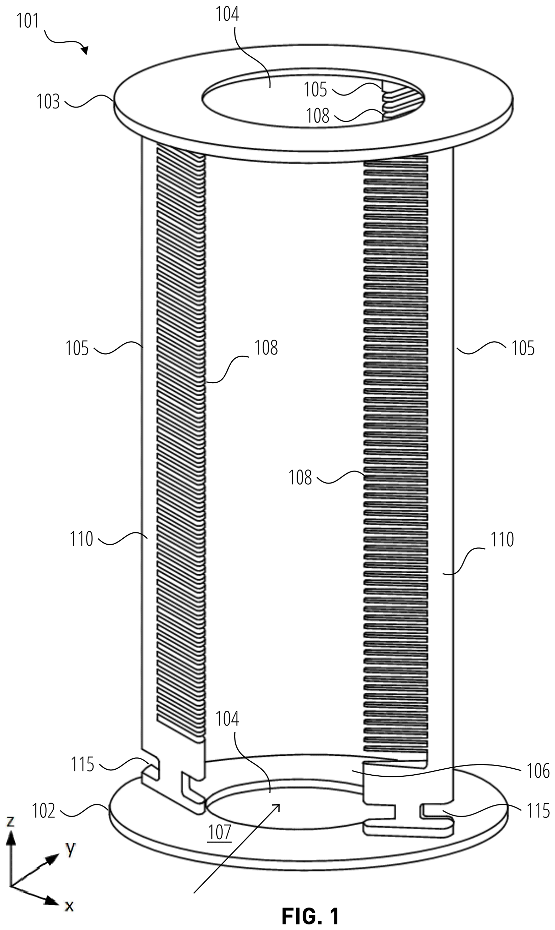

Referring to FIG. 1, FIG. 2, and FIG. 3, a wafer boat 101 for carrying a plurality of wafers according to embodiments of the present invention comprises a bottom member 102 and a top member 103 which are spaced apart in a first direction z. The bottom member 102 and the top member 103 are generally circular shaped and may comprise central regions 104 at which material is removed. This can help to reduce thermal stress on the bottom member 102 and the top member 103 when subjected to large temperature changes.

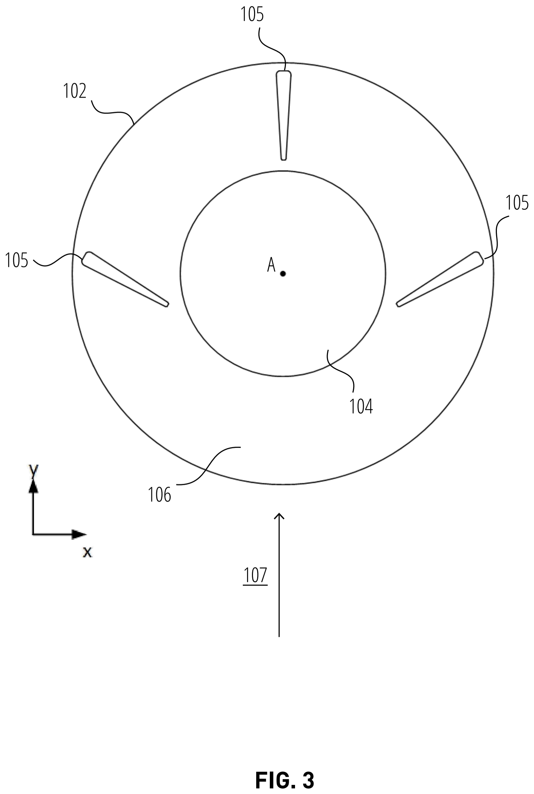

The boat 101 comprises at least three rods 105. Each rod 105 extends between the bottom member 102 and the top member 103. Referring in particular to FIG. 1 and FIG. 3, the rods 105 are positioned so as to provide a wafer insertion opening 106 through which wafers may be inserted into the boat in a wafer insertion direction 107. In some embodiments, one of the rods 105 may be positioned in the wafer insertion direction 107 and this may be referred to as a back rod, the other rods 105 being referred to as side rods. In some embodiments, the at least three rods 105 comprises at least four rods 105.

Each rod 105 comprises a plurality of wafer supports 108. The wafer supports 108 are provided spaced apart in the first direction, so as to provide a plurality positions in a plane perpendicular to the first direction at which wafers can be supported. The supports 108 may be provided by forming slits 109 in the rod 105, leaving a main body 110 of the rod 105 as being without slits 109. The supports 108 may be formed by providing projections extending from a main body 110 of the rod 105. The supports 108 may be equally spaced apart in the first direction, that is, a distance between one support and an adjacent support on the same rod 105 may not vary between pairs of adjacent supports. The boat 101 may comprise at least 100, at least 120, or at least 140 supports 108 per rod 105. The boat 101 may be made of silicon.

Each rod 105 comprises an upper section 111, at which the rod 105 attaches to the top member 103, and a lower section 112 at which the rod 105 attaches to the bottom member 102. The rod 105 may be attached, for example, using bonding methods such as gluing, welding, or bolting. The upper section 111 and the lower section 112 may comprise no supports 108. The upper section 111 is provided between a topmost support 113 of the supports 108 and the top member 103. The lower section 112 is provided between a bottom-most support 114 of the supports 108 and the bottom member 102.

Each rod 105 comprises a stress control cut-out region 115 for limiting thermal stresses between the rod 105 and the bottom member 102. The stress control cut-out region 115 is a region of the rod 105 in which material is removed such that a cross-section of the rod in a plane perpendicular to the first direction at a position of the cut-out region 115 is different to a cross-section of the rod in a plane perpendicular to the first direction at a position away from the cut-out region. The cut-out region 115 may be provided in the lower section 112. By providing the stress control cut-out region 115, stress on the bottom member 102 at high temperatures, e.g. due to nonuniform cooling of the boat 101 and/or deformation of the rod 105, can be reduced. Without being bound by theory, it is thought that by removing material from the rod 105 in a controlled way at the cut-out region(s), the rod 105 may increase in flexibility at high temperatures and behave as an expansion joint, able to withstand an increased amount of bending without damage to the bottom member 102 than a rod without the cut-out region 115.

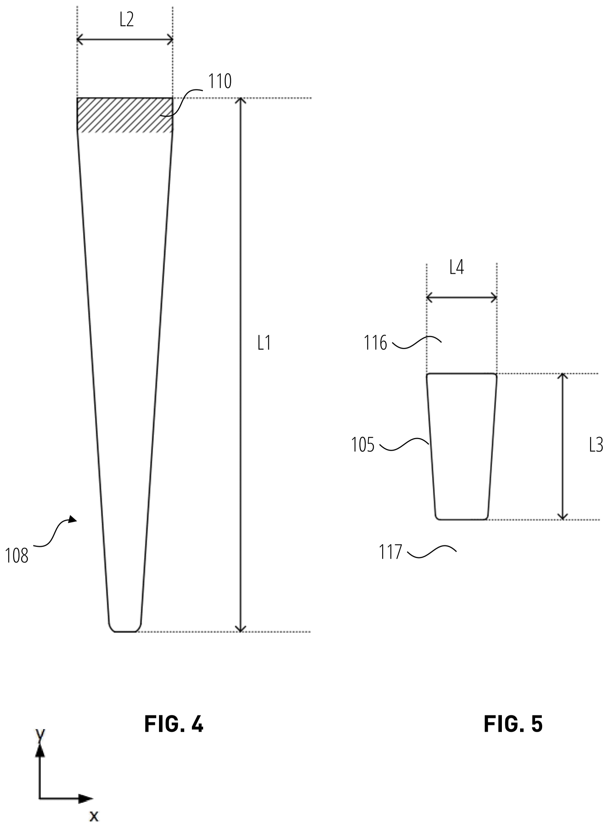

Each support 108 may have a finger-type shape in a plane perpendicular to the first direction. For example, referring to FIG. 4, each rod may have a first length L1 at a wafer support position in a second direction y perpendicular to the first direction z, and a second length L2 at the wafer support position in a third direction x perpendicular to the first direction z and the second direction y, and the first length L1 may be greater than the second length L2. A wafer support position is a position along the first direction at which a wafer support is provided. A wafer support position is not a position along the first direction at which a gap (e.g., slit 109) between wafer supports is provided or a position along the first direction at which a cut-out region 115 is provided.

A cross-sectional profile of a rod 105 in a plane perpendicular to the first direction may be the same as the shape shown in FIG. 4, at positions away from gaps between wafer supports and away from cut-out regions 115, 120.

In some embodiments, the first length L1 may vary along the third direction, for example due to corner rounding. In some embodiments, the second length L2 may vary along the second direction, for example due to corner rounding and/or tapering towards an end of the support 108. However, a minimum of the first length L1 may always be greater than a maximum of the second length L2. A minimum value of the first length L1 may be at least twice, at least three times, or at least four times a maximum value of the second length L2. Providing finger shaped supports 108 may allow for reduced slip between wafer and support, for example in high temperature processes.

The cut-out region 115 may be provided as a single cut-out region in each rod. The cut-out region 115 may comprise a first cut-out region 116 at one edge of a rod 105 and a second cut-out region 117 at an opposite edge of a rod 105. The first cut-out region 116 and the second cut-out region 117 may be spaced apart in the second direction. The first cut-out region 116 and the second cut-out region 117 may be made in opposite edges 118, 119 of the rod 105 respectively, the opposite edges 118, 119 being spaced apart in the second direction. The first cut-out region 116 and the second cut-out region 117 may be provided at substantially a same position in the first direction. In some embodiments, the first cut-out region 116 and/or the second cut-out region 117, may form open cut-outs in the rod 105. The first cut-out region 116 and the second cut-out region 117 may have substantially a same shape. The first cut-out region 116 and the second cut-out region 117 may have different shapes.

In some embodiments, the cut-out region 115, for example the first cut-out region 116 and the second cut-out region 117, are provided so as to reduce the length of the rod 105 in the second direction at a position of the cut-out regions. The length reduction may be constant over a height of the cut-out region 115, or may vary. For example, a cut-out region 115 may have a greater length in the second direction at a point closer to the bottom member 102 than at a point further from the bottom member 102. This may help to provide additional stability to the rod 105.

In some embodiments, a length L3 of the rod 105 in the second direction at a position of the cut-out region 115 is less than a length L1 of the rod 105 in the second direction at a position in the lower section 112 which is between the bottom member 102 and the cut-out region 115 in the first direction, and is less than of a length of the rod in the second direction at a position in the lower section 112 which is between the cut-out region 115 and the bottom-most support 114 in the first direction.

In some embodiments, a length L3 of the rod 105 in the second direction at a position of the cut-out region 115 is between 20% and 70% of a length L1 of the rod 105 in the second direction at a position in the lower section 112 which is between the bottom member 102 and the cut-out region 115 in the first direction and is between 20% and 70% of a length of the rod in the second direction at a position in the lower section 112 which is between the cut-out region 115 and the bottom-most support 114 in the first direction.

In some embodiments, a length L3 of the rod 105 in the second direction at a position of the cut-out region 115 is between 20% and 40% of a length L1 of the rod 105 in the second direction at a position in the lower section 112 which is between the bottom member 102 and the cut-out region 115 in the first direction and is between 20% and 40% of a length of the rod in the second direction at a position in the lower section 112 which is between the cut-out region 115 and the bottom-most support 114 in the first direction.

In some embodiments, a length L3 of the rod 105 in the second direction at a position of the cut-out region 115 is between 40% and 60% of a length L1 of the rod 105 in the second direction at a position in the lower section 112 which is between the bottom member 102 and the cut-out region 115 in the first direction and is between 40% and 60% of a length of the rod in the second direction at a position in the lower section 112 which is between the cut-out region 115 and the bottom-most support 114 in the first direction.

In some embodiments, a length L3 of the rod 105 in the second direction at a position of the cut-out region 115 is between 30% and 40% of a length L1 of the rod 105 in the second direction at a position in the lower section 112 which is between the bottom member 102 and the cut-out region 115 in the first direction and is between 30% and 40% of a length of the rod in the second direction at a position in the lower section 112 which is between the cut-out region 115 and the bottom-most support 114 in the first direction.

The cut-out regions 115 may be generally square shaped, or rectangular, or circular, or elliptical or any suitable shape. In some embodiments, a single cut-out region 115 may be provided in each rod 105. The single cut-out region 115 may be provided, for example, at an edge 119 of the rod 105 which faces away from a central axis A of the boat.

The cut-out region 115 or regions 115 are preferably provided so as to reduce the length of the rod 105 at the position of the cut-out region in the second direction only. The length L4 of the rod in the third direction at a position of the cut-outs may vary along the second direction due to a tapering of the rod 105 but not due to provision of any cut out. Put differently, the length L4 of the rod in the third direction at a position of the cut-outs may be the same as a length of the rod in the third direction at a wafer support position, wherein both measurements are taken at a same position in the x-y plane.

The cut-out region(s) 115, for example the first cut-out region 116 and the second cut-out region 117, may each have a height H1 in the first direction which is greater than a distance D in the first direction between adjacent wafer supports on a rod 105. For example, the height H1 may be at least two times, at least three times, at least four times the distance D. The height H1 of the cut-out region 115 may be chosen in order to balance the increase in flexibility provided by increased height of the cut-out region 115 with the less desirable increase in thermal gradient caused by such increased height.

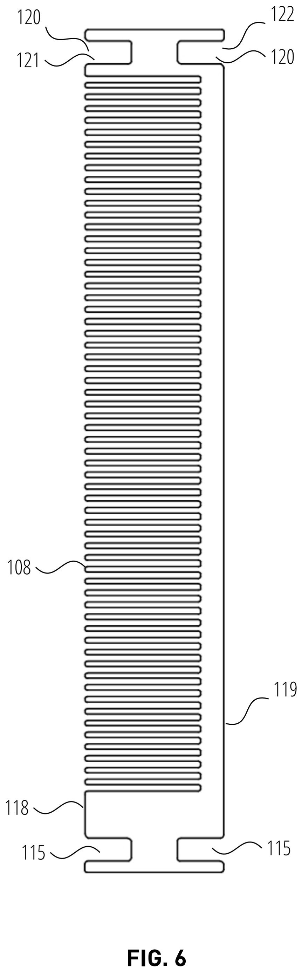

Referring to FIG. 6, in some embodiments, each rod 105 includes an additional stress control cut-out region to limit thermal stresses between the rod 105 and the top member 103. The additional stress control cut-out region may be referred to as an upper cut-out region 120. The upper cut-out region 120 is a region of the rod 105 in which material is removed such that a cross-section of the rod in a plane perpendicular to the first direction at a position of the upper cut-out region 120 is different to a cross-section of the rod in a plane perpendicular to the first direction at a position away from the upper cut-out region 120. The upper cut-out region 120 may be provided in the upper section 111. By providing the stress control upper cut-out region 120, stress on the top member 103 at high temperatures, e.g. due to nonuniform cooling of the boat 101 and/or deformation of the rod 105, can be reduced.

The upper cut-out region 120 may be provided as a single cut-out region in each rod. The upper cut-out region 120 may comprise a first upper cut-out region 121 at one edge of a rod 105 and a second upper cut-out region 122 at an opposite edge of a rod 105. The first upper cut-out region 121 and the second upper cut-out region 122 may be spaced apart in the second direction. The first upper cut-out region 121 and the second upper cut-out region 122 may be made in opposite edges 118, 119 of the rod 105 respectively, the opposite edges 118, 119 being spaced apart in the second direction. The first upper cut-out region 121 and the second upper cut-out region 122 may be provided at substantially a same position in the first direction. In some embodiments, the first upper cut-out region 121 and/or the second upper cut-out region 122 may form open cut-outs in the rod 105. In some embodiments, the first upper cut-out region 121 and/or the second upper cut-out region 122 may be through holes in the rod 105. The first upper cut-out region 121 and the second upper cut-out region 122 may have substantially a same shape. The first upper cut-out region 121 and the second upper cut-out region 122 may have different shapes.

In some embodiments, the upper cut-out region 120, for example the first upper cut-out region 121 and the second upper cut-out region 122, are provided so as to reduce the length of the rod 105 in the second direction at a position of the cut-out regions. The length reduction may be constant over a height of the upper cut-out region 120, or may vary. For example, an upper cut-out region 120 may have a greater length in the second direction at a point closer to the top member 103 than at a point further from the top member 103. This may help to provide additional stability to the rod 105.

In some embodiments, a length of the rod 105 in the second direction at a position of the upper cut-out region 120 is less than a length of the rod 105 in the second direction at a position in the upper section 111 which is between the top member 103 and the upper cut-out region 120 in the first direction, and is less than of a length of the rod in the second direction at a position in the upper section 111 which is between the upper cut-out region 120 and the topmost support 113 in the first direction.

In some embodiments, a length of the rod 105 in the second direction at a position of the upper cut-out region 120 is between 20% and 70% of a length of the rod 105 in the second direction at a position in the upper section 111 which is between the top member 103 and the upper cut-out region 120 in the first direction, and is between 20% and 70% of a length of the rod in the second direction at a position in the upper section 111 which is between the upper cut-out region 120 and the topmost support 113 in the first direction.

In some embodiments, a length of the rod 105 in the second direction at a position of the upper cut-out region 120 is between 20% and 40% of a length of the rod 105 in the second direction at a position in the upper section 111 which is between the top member 103 and the upper cut-out region 120 in the first direction, and is between 20% and 40% of a length of the rod in the second direction at a position in the upper section 111 which is between the upper cut-out region 120 and the topmost support 113 in the first direction.

In some embodiments, a length of the rod 105 in the second direction at a position of the upper cut-out region 120 is between 40% and 60% of a length of the rod 105 in the second direction at a position in the upper section 111 which is between the top member 103 and the upper cut-out region 120 in the first direction, and is between 40% and 60% of a length of the rod in the second direction at a position in the upper section 111 which is between the upper cut-out region 120 and the topmost support 113 in the first direction.

In some embodiments, a length of the rod 105 in the second direction at a position of the upper cut-out region 120 is between 30% and 40% of a length of the rod 105 in the second direction at a position in the upper section 111 which is between the top member 103 and the upper cut-out region 120 in the first direction, and is between 30% and 40% of a length of the rod in the second direction at a position in the upper section 111 which is between the upper cut-out region 120 and the topmost support 113 in the first direction.

The upper cut-out regions 120 may be generally square shaped, or rectangular, or circular, or elliptical or any suitable shape. In some embodiments, a single upper cut-out region 120 may be provided in each rod 105. The single upper cut-out region 120 may be provided, for example, at an edge 119 of the rod 105 which faces away from a central axis A of the boat.

The upper cut-out region or regions 120 are preferably provided so as to reduce the length of the rod 105 at the position of the additional stress control cut-out region in the second direction only. The length L4 of the rod in the third direction at a position of the cut-outs may vary along the second direction due to a tapering of the rod 105 but not due to provision of any cut out. Put differently, the length L4 of the rod in the third direction at a position of the cut-outs may be the same as a length of the rod in the third direction at a wafer support position, wherein both measurements are taken at a same position in the x-y plane.

The cut-out region(s) 120, for example the first upper cut-out region 121 and the second upper cut-out region 122, may each have a height in the first direction which is greater than a distance D in the first direction between adjacent wafer supports on a rod 105. For example, the height may be at least two times, at least three times, at least four times the distance D.

The cut-out region 115 and/or the upper cut-out region 120 may comprise more than one cut-out spaced apart in the first direction, while all cut-outs in the cut-out region 115 remain between the bottom-most support 114 and the bottom member 102, and all cut-outs in the upper cut-out region 120 remain between the topmost support 113 and the top member 103.

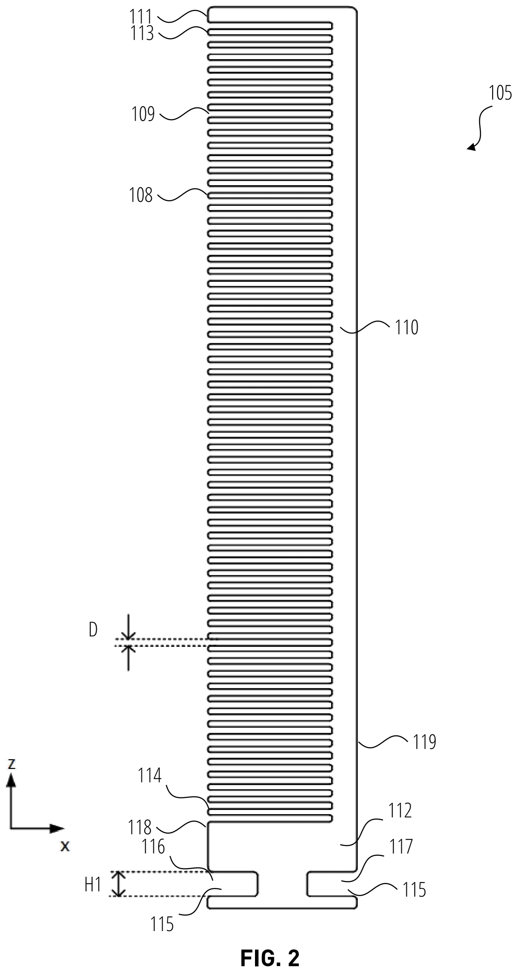

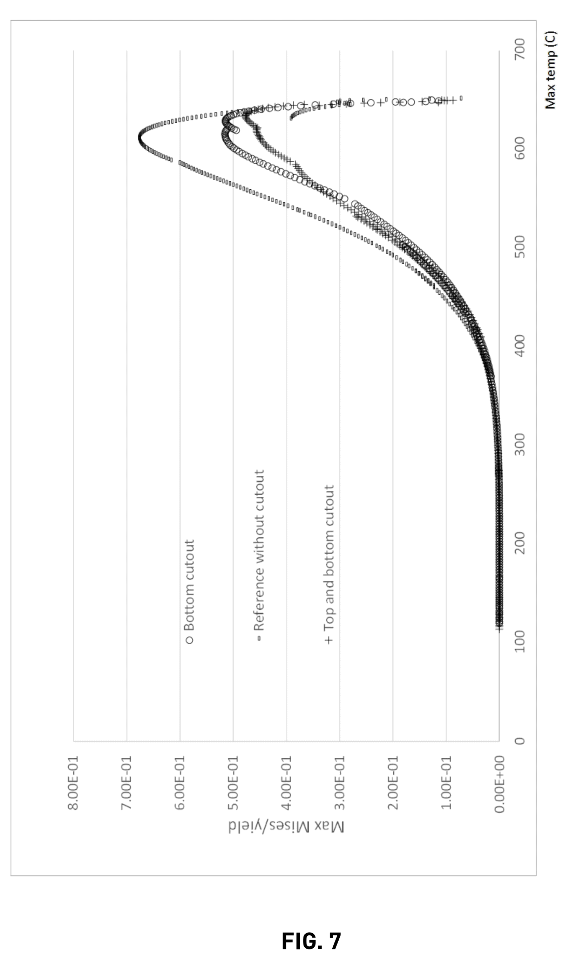

Referring to FIG. 7, results of a finite element thermomechanical simulation of two boats according to embodiments of the present invention along with a reference boat are shown. The boats according to embodiments of the present invention include a boat having stress control cut-out regions only at the lower section 112, as shown in FIG. 2, and a boat having stress control cut-out regions at the lower section 112 and the upper section 111, as shown in FIG. 6. The boats all comprise 119 slots per rod. The reference boat has no stress control cut out regions. For each temperature value, the thermomechanical behaviour of the boat was calculated for a process of heating the boat to that temperature value and then cooling down the boat. The maximum von Mises stress criterion divided by the yield stress is shown as a function of maximum temperature. It can be seen that the ratio is reduced for all temperature values for both of the boats according to embodiments of the present invention with respect to the reference boat. In some cases, it may be preferable to provide stress control cut-out regions only in the lower section 112, as including stress control cut-out regions in the upper section 111 may require the number of wafer support positions to be reduced, which may impact throughput.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A wafer boat for carrying a plurality of wafers, the wafer boat comprising a bottom member, a top member, and at least three rods, each rod extending between the bottom member and the top member and comprising a plurality of wafer supports, wherein each rod comprises a stress control cut-out region to limit thermal stresses between the rod and the bottom member.

2. The wafer boat of claim 1, wherein the cut-out region is provided between the bottom member and a support in the plurality of wafer supports which is closest to the bottom member.

3. The wafer boat of claim 1 or 2, wherein the bottom member and the top member are spaced apart in a first direction, wherein each rod has a length, at a wafer support position, in a second direction perpendicular to the first direction which is greater than a length, at a wafer support position, in a third direction perpendicular to the first direction and the second direction.

4. The wafer boat of claim 3, wherein a minimum length of a rod in the second direction is at least three times a maximum length of the rod in the third direction.

5. The wafer boat of claim 3 or 4, wherein the cut-out regions are provided so as to reduce the length of the rod in the second direction at a position of the cut-out regions.

6. The wafer boat of claim 5, wherein a length of the rod in the second direction at a position of the cut-out regions is between 20% and 70% of a length of the rod in the second direction at a wafer support position.

7. The wafer boat of claim 5 or 6, wherein the cut-out regions are provided at a first side of the boat rod and at a second, opposite side of the boat rod, wherein the first side and the second side are spaced apart in the second direction.

8. The wafer boat of claim 7, wherein each cut-out region on a rod has substantially a same shape.

9. The wafer boat of any one of claims 3 to 8, wherein no cut-out region is provided so as to reduce the length of the rod in the third direction at a position of the cut-out regions.

10. The wafer boat of any one of claims 1 to 8, wherein each rod comprises an additional stress control cut-out region to limit thermal stresses between the rod and the top member.

11. The wafer boat of claim 10, wherein the additional stress control cut-out region is provided between the top member and a support in the plurality of wafer supports which is closest to the top member.

12. The wafer boat of any one of claims 1 to 11, wherein the plurality of wafer supports are finger shaped.

13. The wafer boat of any one of claims 1 to 12, comprising silicon.

14. The wafer boat of any one of claims 1 to 13, comprising at least 100 wafer supports.
